# FASCICULE DE BREVET EUROPEEN

(11) **EP 3 662 511 B1**
(45) Date de publication et mention de la délivrance du brevet: **30.08.2023**
(21) Numéro de dépôt: 18743543.3
(22) Date de dépôt: 30.07.2018
(51) Int. Cl.: H01L 27/146

(54) **DÉTECTEUR INFRAROUGE AMÉLIORÉ**
VERBESSERTER INFRAROTDETEKTOR
IMPROVED INFRARED DETECTOR

(30) Priorité: 03.08.2017 FR 1700825
(43) Date de publication de la demande: 10.06.2020
(73) Titulaire: THALES, 92400 Courbevoie (FR); Commissariat à l'Énergie Atomique et aux Énergies Alternatives, 75015 Paris (FR)
(72) Inventeur: DELGA, Alexandre, 91767 Palaiseau Cedex (FR); REVERCHON, Jean-Luc, 91767 Palaiseau Cedex (FR)
(74) Mandataire: Atout PI Laplace
(86) Numéro de dépôt international: PCT/EP2018/070555
(87) Numéro de publication internationale: WO 2019/025342

(56) Documents cités:
- EP-A1- 3 190 621
- WO-A1-2013/079603
- US-A1- 2016 322 516
- A ROGALSKI: "Infrared detectors: an overview", INFRARED PHYSICS & TECHNOLOGY, vol. 43, no. 3-5, 1 juin 2002 (2002-06-01) , pages 187-210, XP055007585, ISSN: 1350-4495, DOI: 10.1016/S1350-4495(02)00140-8
- LEE, S. J. ET AL.: "A monolithically integrated plasmonic infrared quantum dot camera", NATURE COMMUNICATIONS, vol. 2, 286, 19 avril 2011 (2011-04-19), XP002780246, DOI: 10.1038/ncomms1283

## Description

### DOMAINE DE L'INVENTION

L'invention concerne le domaine des détecteurs optiques matriciels de type hybride pour imagerie infrarouge. L'imagerie infrarouge correspond à des longueurs d'onde comprises entre 900 nm et 25 µm. Dans ce domaine les détecteurs utilisent une couche photo absorbante en matériau semi conducteur.

### ETAT DE LA TECHNIQUE

Les imageurs opérant dans la gamme infrarouge sont généralement constitués par assemblage d'une matrice comprenant une pluralité de pixels élémentaires à base de photodiodes transformant un flux de photons incidents en porteurs photogénérés, et d'un circuit de lecture couramment dénommé ROIC pour « Read Out Integrated Circuit » en anglais pour traiter le signal électrique issu des pixels du détecteur. On dénomme cet assemblage hybridation.

Une technologie bien connue d'hybridation utilise des billes d'indium destinées à la connexion électrique de la matrice au circuit de lecture et permet la compensation des différences de coefficients de dilatation thermique entre circuit de lecture et matrice de photodiodes. Cette configuration n'est pas vitale dans le cas de composants non refroidis, par exemple du type InGaAs sur substrat InP. US 2016/322516 A1 divulgue un capteur hybride selon l'art antérieur.

Une autre technologie utilise l'assemblage par collage du circuit ROIC avec l'imageur, ce qui pose le problème de la connexion électrique entre la matrice de photodiodes et les contacts associés du circuit ROIC.

Une structure résolvant ce problème comprend des trous d'interconnexion dénommés en anglais « via-hole » et des photodiodes de symétrie cylindrique autour de ces trous d'interconnexion. Cette photodiode est communément appelée « loop-hole ». Cette structure, consistant à réaliser un imageur infrarouge en couplant interconnexion 3D (circuit ROIC) et photodiode cylindrique, est connue depuis les années 80.

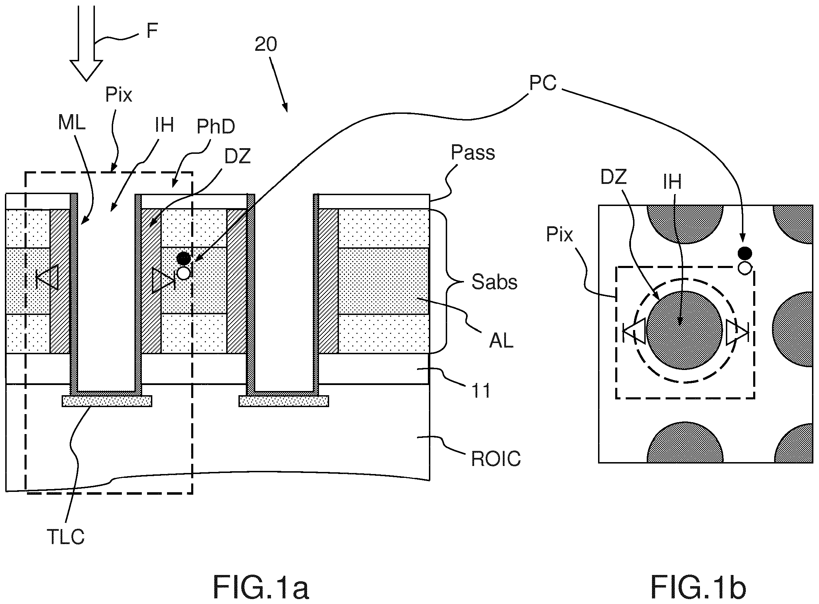

Un détecteur optique hybride 20 présentant une matrice de photodiodes de type « loop hole » adaptées pour une structure absorbante réalisée avec des matériaux III-V est illustré figure 1, la figure 1a correspondant à une coupe transversale et la figure 1b à une vue de dessus.

La matrice de photodétecteurs comprend une structure absorbante Sabs comprenant au moins une couche absorbante AL en matériau III-V, apte à générer des porteurs PC à partir d'un flux de photons incidents F. La structure Sabs est recouverte d'une couche de passivation Pass. Cette structure est assemblée au circuit ROIC par une couche d'assemblage 11, typiquement un diélectrique.

Les contacts du circuit de lecture ROIC destinés à recevoir le signal électrique généré par chaque pixel Pix du détecteur sont des contacts TLC enterrés dénommés « Top Level Contacts » en anglais. Ils sont réalisés en fin de procédé de fabrication des circuits intégrés, et sont localisés proches de la surface du circuit.

Dans une matrice de type « loop hole » une diode cylindrique PhD est réalisée autour d'un trou d'interconnexion IH, qui traverse la structure absorbante, la couche d'assemblage 11 et le circuit ROIC jusqu'au contact TLC. Les parois du trou IH sont recouvertes d'une couche de métallisation ML, réalisant la liaison électrique entre la diode PhD et le contact TLC.

La diode PhD est réalisée par dopage localisé d'une zone DZ proche du trou IH (p dans l'exemple de la figure 1) d'un type opposé au dopage initial de la couche absorbante AL (n dans l'exemple de la figure 1). La photodiode de type p-n réalise la séparation et le transport des porteurs photo-générés vers la couche de métallisation ML et collecte les porteurs minoritaires (les trous lorsque la zone DZ est dopée p).

De manière générale la technologie « Loop hole » est compatible de diodes pn ou np.

Le document WO2013079603 décrit une méthode de fabrication d'un détecteur 20 à base de diodes « loop hole » tel que décrit ci-dessus, avec une couche absorbante AL en matériau III-V. Un exemple est une couche absorbante en InGaAs dopée n disposée entre deux couches d'encapsulation en InP. Le détecteur 20 du document WO2013079603 présente une configuration d'illumination spécifique à travers le substrat, et un double imageur Visible/IR.

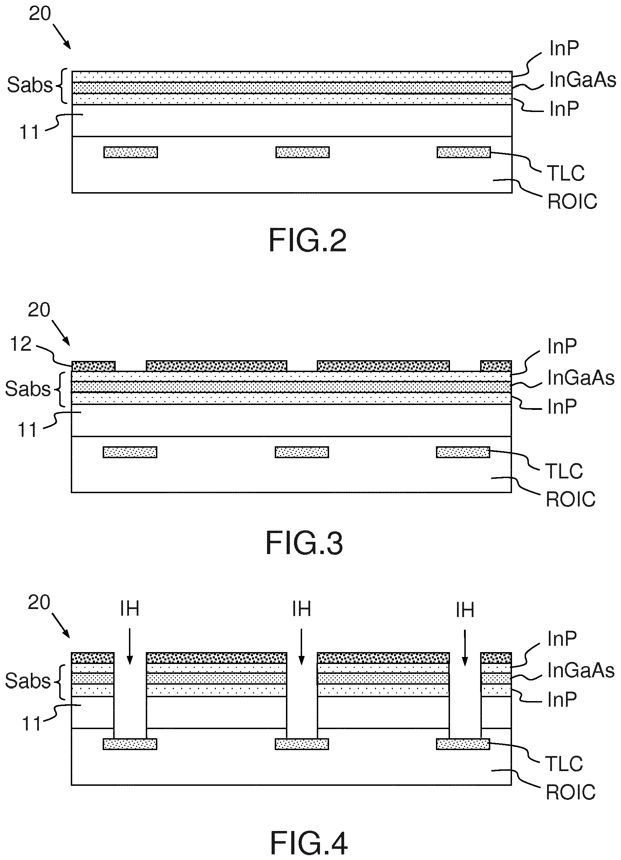

Le principe du procédé est illustré figures 2 à 6.

Dans une première étape illustrée figure 2 une structure semi-conductrice Sabs comprenant les trois couches précitées est assemblée, via une couche d'assemblage 11, à un circuit de lecture ROIC présentant des contacts enterrés TLC. L'assemblage est réalisé par collage, technique en plein développement et qui constitue un progrès important pour la réalisation d'étapes technologiques dites « above IC », c'est-à-dire d'étapes réalisables directement sur la plaque du circuit de lecture ROIC, typiquement de type CMOS, et de manière collective sur l'ensemble des puces. Cette compatibilité avec les moyens de fabrication CMOS est adaptée à une baisse significative des coûts de production et à la possibilité d'atteindre des motifs technologiques de taille plus fine.

Puis on dépose un diélectrique de masquage 12 sur la structure Sabs, et on effectue une gravure d'une partie de la couche diélectrique de masquage en regard des contacts TLC tel que représenté figure 3.

Les trous d'interconnexion IH sont réalisés par gravure verticale jusqu'aux contacts TLC, au travers de la structure absorbante et de la couche d'assemblage illustré figure 4. La gravure est réalisée par voie sèche ou par voie humide.

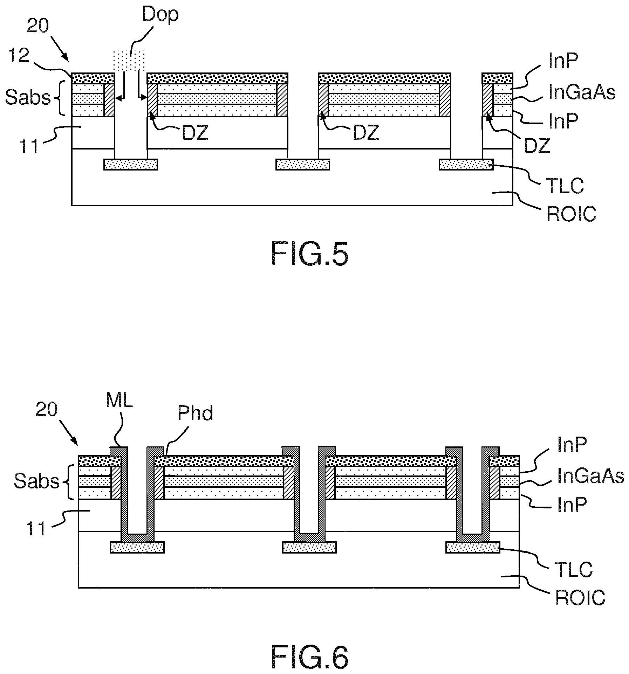

Lors d'une étape illustrée figure 5, on réalise une zone dopée DZ, par exemple de type p, par diffusion ou implantation ionique d'un dopant Dop via chaque trou IH, de manière à former une photodiode PhD comprenant une jonction p-n cylindrique. La diffusion s'opère à partir de la surface des parois du trou IH, et en parallèle au travers de toutes les couches composant la structure absorbante.

Dans une étape finale illustrée figure 6 on procède au dépôt d'une couche métallique ML sur les parois des trous IH de manière à mettre en contact électrique la zone dopée DZ et le contact TLC.

Ainsi le procédé de réalisation de la diode « loop hole » est réalisé après l'assemblage avec le circuit ROIC.

Le détecteur décrit figure 1 présente cependant quelques inconvénients. Pour améliorer les performances du détecteur, on dépose une couche antireflet directement sur le détecteur, ce qui augmente le nombre d'étapes technologiques.

Lorsque l'on cherche à diminuer la taille des pixels, apparait le problème de diaphonie entre pixels voisins et de dégradation de la fonction de transfert ou FTM. La diaphonie entre pixels peut être d'origine optique (un photon se propage dans le matériau avant d'être absorbé dans un pixel voisin) ou électrique (un porteur électrique diffuse d'un pixel à l'autre).

Pour réduire la diaphonie optique et améliorer la FTM, l'idée d'utiliser des matrices de microlentilles à proximité d'un plan focal existant est connue de l'état de la technique mais pose des problèmes technologiques majeurs :
Pour des microlentilles plan-convexes fabriquées ex-situ et déposées post hybridation, les difficultés d'alignement et d'uniformité sur la matrice sont rédhibitoires.

Pour les microlentilles plan-convexes de Fresnel, la définition du profil 3D de la lentille par ablation laser est difficile. La fabrication additive pose également des problèmes (voir document US7199931).

La technologie planaire de microlentilles de Fresnel digitalisées utilisant la notion d'indice effectif (on crée un matériau effectif d'épaisseur constante mais d'indice variable en variant le facteur de remplissage entre deux matériaux d'indice différents) nécessite une structuration largement sub-longueur d'onde du matériau imposant le recours à la lithographie électronique pour les longueurs IR. La précision nécessaire à leur fabrication sur un détecteur unitaire est rédhibitoire.

Un autre problème est que dans un système d'imagerie, les pixels du détecteur voient chacun des faisceaux incidents avec des angles moyens et des ouvertures angulaires différents, fonction de la distance du pixel à l'axe optique du système, ce qui rend l'utilisation de matrices de microlentille plus complexe.

Dans une structure « loop hole » les trous d'interconnexions retirent une surface non négligeable du côté par lequel la lumière éclaire le détecteur, précisément au point de focalisation de la microlentille, ce qui rend l'utilisation de microlentilles peu pertinente.

Par ailleurs une nouvelle génération de composants de type micro optique a récemment vu le jour, fondée sur une transposition en optique du phénomène de rayonnement d'une antenne, jusqu'ici mis en oeuvre pour le domaine hyperfréquence. Ces composants sont par exemple décrits dans le document WO2013/033591. Des résonateurs, d'une taille de l'ordre de grandeur de la longueur d'onde, réémettent (rayonnent), à partir d'une onde incidente, une lumière présentant une longueur d'onde de résonance, par modification de la phase de l'onde incidente. Cette modification ne s'effectue pas au cours d'une propagation d'un rayon lumineux comme c'est le cas classiquement, mais de façon abrupte. On parle alors de « metasurface ». A noter que ce principe physique diffère de celui de l'indice effectif, dans lequel la phase est également imprimée au cours de la propagation le long d'un chemin optique par des éléments de dimension sub-longueur d'onde.

Un photon incident sur un point de la micro optique est capté par une nano antenne précise, interagit avec elle, et est réémis avec une phase donnée. Chaque nano antenne interagit avec l'onde incidente en lui imprimant une modulation de phase, et/ou d'amplitude, et/ou de polarisation. L'arrangement de ces résonateurs permet de modeler le front d'onde incident afin d'assurer la fonction optique souhaitée, ce qui ouvre un vaste champ d'ingénierie de front d'onde.

Un premier type de résonateur est de type MIM (Métal/Isolant/ Substrat Métal) ou plus généralement Conducteur/lsolant/Substrat (couramment dénommé antenne plasmonique), et fonctionne en réflexion uniquement. Un deuxième type de résonateur est de type diélectrique (sur substrat diélectrique) et peut fonctionner en réflexion ou en transmission.

Chaque résonateur est un dipôle rayonnant ou dipôle de Huygens (méta-surface de Huygens) et un nombre important de modes d'antenne sont accessibles en jouant sur la forme, la taille et l'agencement de ces dipôles.

Pour les résonateurs diélectriques ce sont les interférences entre ces différents modes d'antenne (par exemple résonance dipolaire/quadrupolaire électriques et magnétiques) qui sont ajustées pour être constructives vers l'avant et destructives vers l'arrière (fonctionnement en transmission), ou inversement constructives vers l'arrière et destructives vers l'avant (fonctionnement en réflexion). L'ingénierie de ces résonances et de leurs diagrammes de rayonnement confèrent un grand nombre de degrés de libertés pour le modelage (spatial et spectral) du front d'onde incident.

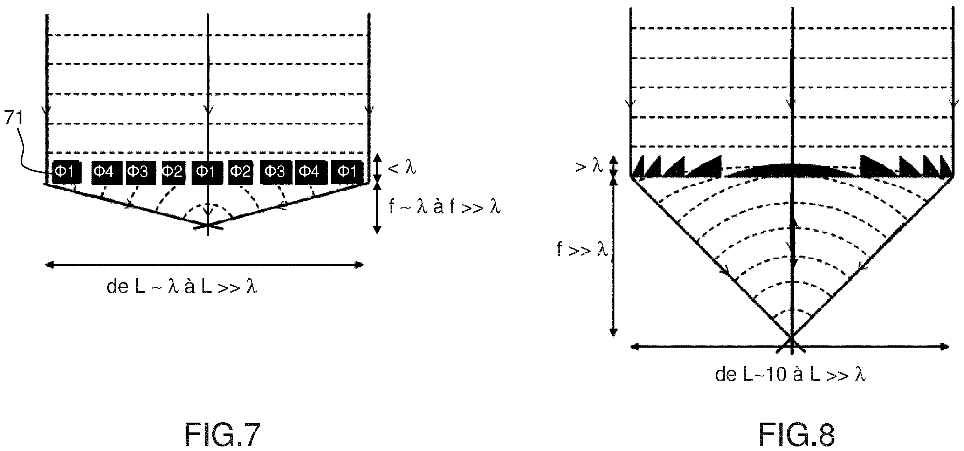

Un exemple de microlentille réalisée avec une méta-surface est illustré figure 7. Une lentille classique de type Fresnel est illustrée figure 8 à titre comparatif. Dans le cas d'une lentille de Fresnel (ou d'une microlentille classique) les dimensions (épaisseur de la lentille, distance focale) sont très grandes devant la longueur d'onde d'utilisation : le modelage du front d'onde se fait sur de nombreuses oscillations. Dans le cas d'une métasurface, ce sont les nano résonateurs 71 qui confèrent directement les phases Φ1, Φ2, Φ3, Φ4 nécessaires au modelage du front d'onde, sans qu'une propagation soit nécessaire. Toutes les dimensions, y compris la distance focales, peuvent être de l'ordre de la longueur d'onde.

A titre d'exemple le document « Robust design of microlenses arrays employing dielectric resonators metasurfaces » de Silvesti et al (SPIE vol 10113) décrit une méthode de design de microlentilles basée sur une optimisation de nuées particulaires « particule swarm optimization routine » en anglais. Les microlentilles sont réalisées avec des résonateurs diélectriques cylindriques en GaN (indice 2.55) ou en Silicium (indice 3.87) sur un substrat en SiO₂ (indice 1.47). La modification de la phase est obtenue en modifiant le rayon des résonateurs. Le fort écart d'indice entre matériau du résonateur et substrat justifie l'appellation « high contrast dielectric resonators », et est mis à profit pour augmenter la section efficace des nano-antennes, et réduire la densité nécessaire de résonateurs pour un modelage donné.

Un but de la présente invention est de pallier certains des inconvénients précités en proposant un détecteur optique de type hybride utilisant de manière originale des nano ou micro résonateurs diélectriques, également dénommés méta-surface de Huygens, selon une structure compatible avec plusieurs types de détecteurs hybrides.

### DESCRIPTION DE L'INVENTION

La présente invention a pour objet un détecteur optique de type hybride comprenant un empilement selon un axe Z comprenant :
- une structure absorbante sensible dans une bande de longueur d'onde d'intérêt, ladite structure comprenant au moins :
   - une couche absorbante en matériau semi-conducteur III-V ou II-VI dénommé matériau actif, présentant un premier type de dopage choisi parmi n ou p, apte à photogénérer des porteurs par absorption d'une lumière incidente sur ledit détecteur présentant au moins une longueur d'onde comprise dans la bande de longueurs d'onde d'intérêt,
   - une couche supérieure en un matériau semi-conducteur III-V ou IV dénommé matériau supérieur, disposée sur la couche absorbante et présentant une surface en contact avec l'extérieur du côté par lequel le détecteur est illuminé et,
- la structure absorbante comprenant en outre, dans au moins une couche, une pluralité de zones dopées d'un deuxième type de dopage choisi parmi n ou p, et configurées pour collecter des porteurs photogénérés par la couche absorbante, une zone dopée permettant de définir un pixel du détecteur,
- un circuit de lecture comprenant une pluralité de contacts enterrés, le circuit de lecture étant destiné à récupérer un signal électrique à partir desdits porteurs photogénérés par la couche absorbante,
- la structure absorbante et le circuit de lecture étant assemblés par une couche d'assemblage pour former le détecteur optique, une connexion électrique entre une zone dopée et un contact du circuit de lecture étant réalisée via des trous d'interconnexion métallisés,
- le détecteur hybride comprenant en outre un ensemble de résonateurs diélectriques gravés dans la couche supérieure et formant une surface supérieure, chaque résonateur étant configuré pour diffuser de manière résonnante, lorsqu'éclairé par la lumière incidente, une lumière présentant au moins une longueur d'onde de résonance comprise dans la bande de longueur d'onde d'intérêt,
une fraction de la surface supérieure associée à un pixel du détecteur comprenant une pluralité de résonateurs diélectriques.

Selon une variante les trous d'interconnexion traversent la structure absorbante et le circuit de lecture jusqu'au contact et dans lequel chaque zone dopée s'étend de manière annulaire autour d'un trou d'interconnexion.

Selon une autre variante les trous d'interconnexion traversent le circuit de lecture et chaque zone dopée est réalisée dans une couche de contact disposée sous la couche absorbante.

Préférentiellement la structure absorbante comprend un substrat formant la couche supérieure, une couche d'interface disposée entre le substrat et la couche absorbante, une couche barrière disposée sous la couche absorbante, la couche de contact comprenant les zones dopées étant disposée sous la couche barrière et en contact avec le circuit de lecture via la couche d'assemblage.

Selon un mode de réalisation, au moins une dimension d'un résonateur choisie parmi largeur, longueur, hauteur, est comprise dans l'intervalle [λ_{R}/2n - 50% ; λ_{R}/2n + 50%] ou dans l'intervalle [ λ_{R}/n - 50% ; λ_{R}/n + 50% ], avec : λ_{R} longueur d'onde de résonance n indice du matériau supérieur

Selon un mode de réalisation chaque fraction de surface supérieure associée à un pixel comprend au moins 5x5 résonateurs diélectriques.

Selon un mode de réalisation les résonateurs diélectriques associés à un pixel sont configurés pour concentrer la lumière rayonnée à la longueur d'onde de résonance dans la zone dopée correspondante.

Selon un mode de réalisation les résonateurs associés à un pixel sont en outre configurés de manière à tenir compte de la position dudit pixel dans le détecteur.

Selon un mode de réalisation les résonateurs sont en outre configurés pour transmettre plus de 70 % de la lumière présentant la longueur d'onde de résonance, et pour réfléchir au moins en partie les autres longueurs d'onde de la bande spectrale d'intérêt.

Selon un mode de réalisation la pluralité de résonateurs associés à un pixel présente un design spécifique audit pixel.

Préférentiellement la bande de longueur d'onde d'intérêt est choisie parmi le proche infrarouge, l'infrarouge moyen, l'infrarouge lointain.

Préférentiellement le matériau actif est choisi parmi les semi conducteurs III-V tels que InGaAs ; InAsSb ; super réseau InAsSb/lnAs ; InSb ; super réseau GaSb/InAs ; multi-puits quantiques AllnAs/InGaAs ; multi-puits quantiques AlGaAs/GaAs ou parmi les semiconducteurs II-VI tel que HgCdTe.

Préférentiellement le matériau supérieur est choisi parmi : InP ; GaAs ; GaSb ; Si ; SiC ; diamant.

Selon un autre aspect l'invention concerne un procédé de fabrication d'un détecteur optique de type hybride comprenant les étapes consistant à :
- Assembler, par une couche d'assemblage, une structure absorbante sensible dans une bande de longueur d'onde d'intérêt avec un circuit de lecture comprenant une pluralité de contacts enterrés, la structure absorbante comprenant au moins:
   - une couche absorbante en matériau semi-conducteur III-V ou II-VI dénommé matériau actif, présentant un premier type de dopage choisi parmi n ou p, apte à photogénérer des porteurs par absorption d'une lumière incidente sur ledit détecteur et présentant au moins une longueur d'onde comprise dans la bande de longueur d'onde d'intérêt,
   - une couche supérieure en un matériau semi-conducteur III-V ou IV dénommé matériau supérieur, disposée sur la couche absorbante et présentant une surface en contact avec l'extérieur du côté par lequel le détecteur est illuminé et,
   le circuit de lecture étant destiné à récupérer un signal électrique à partir desdits porteurs photogénérés par la couche absorbante,
- Réaliser dans au moins une couche de la structure absorbante, une pluralité de zones dopées d'un deuxième type de dopage choisi parmi n ou p, lesdites zones dopées étant configurées pour collecter des porteurs photogénérés par la couche absorbante, une zone dopée et un contact du circuit de lecture étant connectés électriquement via des trous d'interconnexion métallisés, une zone dopée permettant de définir un pixel du détecteur,
- Connecter chaque zone dopée avec le contact associé,
- Réaliser dans la couche supérieure un ensemble de résonateurs diélectriques formant une surface supérieure, chaque résonateur étant configuré pour diffuser de manière résonnante au moins une longueur d'onde de résonance comprise dans la bande de longueur d'onde d'intérêt, une fraction de la surface supérieure associée à un pixel du détecteur comprenant une pluralité de résonateurs diélectriques.

Selon une variante la structure absorbante comprend un substrat formant la couche supérieure, une couche d'interface disposée entre le substrat et la couche absorbante, une couche barrière disposée sous la couche absorbante, et une couche de contact comprenant les zones dopées, disposée sous la couche barrière et en contact avec le circuit de lecture via la couche d'assemblage et dans lequel l'étape de réalisation d'une pluralité de zones dopées comprend les sous étapes consistant à
- réaliser les trous d'interconnexion par gravure du circuit de lecture
- réaliser les zones dopées par dopage de la couche de contact au travers des trous d'interconnexion.

Selon un mode de réalisation le procédé comprend en outre, préalablement à l'étape de réalisation des résonateurs, une étape de report sur un substrat rigide.

Selon une autre variante l'étape de réalisation d'une pluralité de zones dopées comprend les sous étapes consistant à :
- réaliser les trous d'interconnexion par gravure de la structure absorbante et du circuit de lecture jusqu'au contact enterrés,
- réaliser les zones dopées par dopage au travers des trous d'interconnexion, de sorte que chaque zone dopée s'étende de manière annulaire autour du trou d'interconnexion correspondant.

Selon un mode de réalisation le procédé comprend en outre, préalablement à l'étape de réalisation des résonateurs, une étape d'amincissement de la couche supérieure.

Selon un mode de réalisation l'étape de réalisation des résonateurs s'effectue par lithographie puis gravure, la technologie de lithographie étant choisie parmi : par faisceau d'électrons ; par nano-impression ; par lithographie optique,la technologie de gravure étant choisie parmi : gravure ionique ; plasma ; chimique.

D'autres caractéristiques, buts et avantages de la présente invention apparaîtront à la lecture de la description détaillée qui va suivre et en regard des dessins annexés donnés à titre d'exemples non limitatifs et sur lesquels :
La figure 1 déjà citée illustre un détecteur optique hybride selon l'état de l'art présentant une matrice de photodiode de type « loop hole » adaptée pour une structure absorbante réalisée avec des matériaux III-V, la figure 1a correspondant à une coupe transversale et la figure 1b à une vue de dessus.
La figure 2 déjà citée illustre une première étape d'assemblage d'une structure semi-conductrice Sabs à un circuit de lecture ROIC présentant des contacts enterrés TLC via une couche d'assemblage.
La figure 3 déjà citée illustre le dépôt d'un diélectrique de masquage sur la structure Sabs, et la gravure d'une partie de la couche diélectrique de masquage en regard des contacts TLC.
La figure 4 déjà citée illustre la réalisation des trous d'interconnexion IH par gravure verticale jusqu'aux contacts TLC, au travers de la structure absorbante et de la couche d'assemblage.
La figure 5 déjà citée illustre la réalisation d'une zone dopée DZ par diffusion ou implantation ionique d'un dopant via chaque trou d'interconnexion.
La figure 6 déjà citée illustre l'étape finale de dépôt d'une couche métallique sur les parois des trous d'interconnexion.
La figure 7 déjà citée illustre un exemple de microlentille réalisée avec une méta-surface.
La figure 8 déjà citée illustre une lentille classique de type Fresnel à titre comparatif.
La figure 9 illustre une variante de détecteur optique de type hybride dénommée TSV dans laquelle les trous d'interconnexion IH ne sont pas réalisés de manière à traverser la structure absorbante comme dans la structure « loop hole » mais traversent le circuit de lecture ROIC de type CMOS.
La figure 10 schématise un détecteur optique de type hybride selon l'invention pour la variante « TSV »
La figure 11 schématise un détecteur optique de type hybride selon l'invention pour la variante « Loop hole ».
La figure 12 illustre deux exemples de motif de base de résonateurs selon l'invention : une forme circulaire en figure 12a et une forme rectangulaire en figure 12b.
La figure 13 illustre une variante préférée du détecteur selon l'invention dans laquelle les résonateurs diélectriques associés à un pixel sont configurés pour concentrer la lumière rayonnée à la longueur d'onde de résonance λ_{R} dans la zone dopée correspondante.
La figure 14 illustre de manière plus détaillée un détecteur selon l'invention réalisé selon la variante TSV.
La figure 15 illustre de manière plus détaillée un détecteur selon l'invention réalisé selon la variante Loop Hole avec la structure décrite figure 1.
La figure 16 schématise un procédé de fabrication d'un détecteur optique de type hybride selon un autre aspect de l'invention.
La figure 17 schématise de manière plus précise le procédé 200 selonl'invention pour un détecteur en technologie TSV.
La figure 18 illustre les différentes étapes du procédé selon l'invention appliqué à la technologie TSV. La figure 18a illustre l'étape 100, la figure 18b l'étape 110, la figure 18c l'étape 120, la figure 18d l'étape 125 et la figure 18e l'étape 130.

### DESCRIPTION DETAILLEE DE L'INVENTION

Avant de décrire l'invention proprement dite, nous allons décrire une variante de détecteur optique de type hybride particulièrement bien adapté à l'implémentation de l'invention. Cette variante est décrite dans la demande de brevet FR1601066 non encore publiée au moment de la rédaction de la présente demande de brevet.

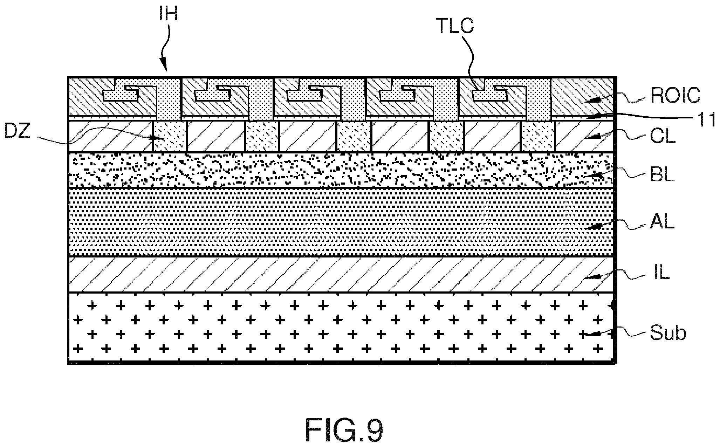

Dans cette variante, illustrée figure 9, les trous d'interconnexion IH ne sont pas réalisés de manière à traverser la structure absorbante comme dans la structure « loop hole » mais traversent le circuit de lecture ROIC de type CMOS. Nous dénommerons cette variante TSV pour « Through Silicon Via » en anglais.

La structure absorbante Sabs comprend dans ce cas : une couche active absorbante AL, un substrat Sub, une couche d'interface IL déposée entre le substrat et la couche active, dont le rôle est d'assurer un bon contact électrique commun tout en limitant la génération de courant d'obscurité ; une couche barrière BL déposée sur la couche absorbante et une couche de contact CL, déposée sur la couche barrière, comprenant les zones dopées DZ.

L'épaisseur globale de la structure le long de la direction d'empilement est comprise entre 0.5 et 10 µm.

La couche barrière, transparente dans la gamme spectrale de fonctionnement du détecteur, peut être non dopée ou faiblement dopée. De manière générale, la couche barrière forme une barrière de potentiel destinée à bloquer les porteurs majoritaires.

On crée la diode par l'empilement des couches verticales, notamment en utilisant une barrière, sans avoir besoin du dopage pour fabriquer la diode (contrairement à la technologie Loop hole) mais seulement pour définir le contact. Et donc la variante TSV présente l'avantage d'être compatible de différentes architectures de diodes, np, pn, nn ou pp.

De manière classique le gap de la couche active est inférieur au gap du substrat et inférieur au gap de la couche d'interface.

Pour la fabrication d'un tel détecteur, après l'assemblage entre la structure absorbante et le circuit de lecture ROIC, les trous d'interconnexion IH sont gravés au travers du circuit de lecture. Puis les zones dopées DZ sont réalisées par dopage de la couche de contact CL au travers des vias IH, par exemple par diffusion ou implantation. Enfin une étape de finalisation de la connectique consiste à réaliser les contacts pour chaque pixel en remplissant les trous IH d'un matériau métallique et en raccordant ce métal avec les contacts TLC.

Préférentiellement la couche absorbante AL de la structure absorbante (pour les deux variantes « loop hole » et « TSV ») est constituée d'un alliage III-V, mais peut également être un matériau II-VI tel le HgCdTe.

Des exemples de matériau actif sont : InGaAs ; InAsSb ; super réseau InAsSb/lnAs ; InSb ; super réseau GaSb/lnAs ; GaN ; AIGaN, AlGaAsSb ; multi-puits quantiques GaAs/AlGaAs ou InGaAs/AllnAs. Chaque couche composant la structure absorbante Sabs est, de manière classique, en accord de maille ou en quasi accord de maille avec la ou les couches adjacentes.

La structure absorbante est réalisée par épitaxie des couches sur un substrat initial Sub.

En variante le substrat Sub de la figure 9 n'est pas le substrat initial. Celui-ci a été retiré et remplacé par un substrat plus rigide présentant une tenue mécanique améliorée, par exemple du silicium ou tout autre matériau rigide utilisé dans les procédés technologique de fabrication industrielle de circuits intégrés. Cette étape de remplacement est effectuée une fois la structure absorbante collée au circuit de lecture.

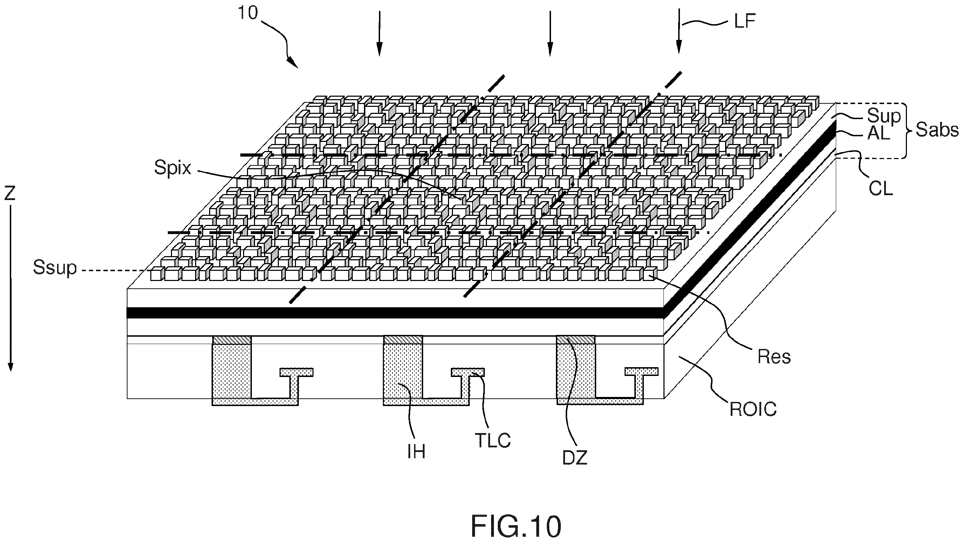

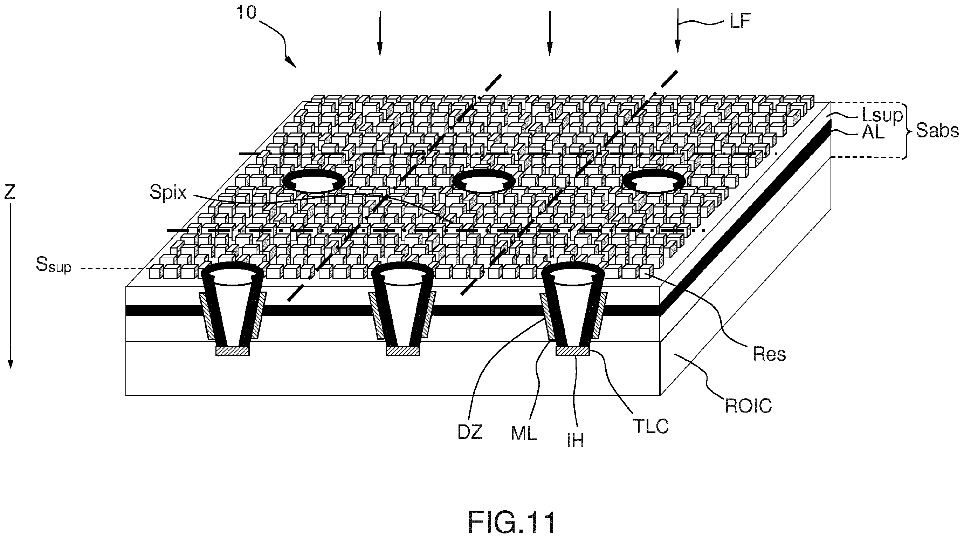

Un détecteur optique 10 de type hybride selon l'invention est illustré figure 10 pour la variante « TSV » et figure 11 pour la variante « Loop hole ».

Nous allons décrire le détecteur selon l'invention de la figure 10.

Le détecteur optique 10 de type hybride selon l'invention comprend un empilement selon un axe Z qui comprend une structure absorbante Sabs et - un circuit de lecture ROIC.

La structure Sabs est sensible dans une bande de longueur d'onde d'intérêt SB. La bande SB est préférentiellement choisie parmi le proche infrarouge [1µm ;2.8µm], l'infrarouge moyen [3 µm ;5µm], l'infrarouge lointain [8 µm ;12µm].

La structure Sabs comprend une couche absorbante AL en matériau semi-conducteur III-V ou II-VI dénommé matériau actif, au moins une couche supérieure Lsup en un matériau semi-conducteur III-V ou IV dénommé matériau supérieur, disposée sur la couche absorbante AL et présentant une surface en contact avec l'extérieur du côté par lequel le détecteur est illuminé.

La couche AL présente un premier type de dopage dop1 choisi parmi n ou p, apte à photogénérer des porteurs par absorption d'une lumière incidente FL sur le détecteur présentant au moins une longueur d'onde comprise dans la bande de longueur d'onde d'intérêt SB.

En fonction de la technologie avec laquelle le détecteur est réalisé, TSV ou Loop Hole, la structure absorbante peut comprendre des couches additionnelles qui seront décrites ultérieurement.

La structure absorbante comprend en outre, dans au moins une couche la constituant, une pluralité de zones dopées DZ d'un deuxième type de dopage dop2 choisi parmi n ou p, et configurées pour collecter des porteurs photogénérés par la couche absorbante AL, une zone dopée permettant de définir un pixel Pix du détecteur. Le choix de dop1 et dop2 dépend des matériaux utilisés, de la bande spectrale d'intérêt ; de l'architecture de la photodiode (cylindrique vs verticale), et de la nature des photoporteurs que l'on souhaite utiliser . De manière générale toutes les combinaisons sont possibles : n-n, p-p, n-p et p-n.

Le circuit de lecture ROIC comprend une pluralité de contacts TLC enterrés et est destiné à récupérer un signal électrique à partir des porteurs photogénérés par la couche absorbante AL, comme expliqué plus haut dans l'état de la technique.

La structure absorbante Sabs et le circuit de lecture ROIC sont assemblés par une couche d'assemblage 11 pour former le détecteur optique 10, une connexion électrique entre une zone dopée et un contact du circuit de lecture ROIC étant réalisée via des trous d'interconnexion IH métallisés. La localisation et la manière de réaliser ces trous d'interconnexion dépendent de la technologie utilisée (voir plus loin).

Le détecteur hybride 10 selon l'invention comprenant en outre un ensemble de résonateurs diélectriques Res gravés dans la couche supérieure Lsup et formant une surface supérieure Ssup en contact avec l'extérieur du détecteur du côté de l'illumination. Chaque résonateur Res est configuré pour diffuser de manière résonnante, lorsqu'éclairé par la lumière incidente LF, une lumière présentant au moins une longueur d'onde de résonance λ_{R} comprise dans la bande SB. La (les) longueur(s) d'onde de résonance est (sont) par exemple choisie(s) en fonction de la courbe d'absorption spectrale de la couche absorbante, ou en fonction de sa bonne transmission par l'atmosphère, garantissant un signal de meilleur qualité, tel par exemple 4.2 µm dans la bande [3µm-5µm].

L'utilisation de plusieurs longueurs d'onde de résonance est pertinente par exemple pour obtenir une information sur le contraste spectral de la scène imagée.

Pour un substrat en matériau supérieur de type III-V, l'indice est typiquement compris entre 2 et 4.5. Les résonateurs Res ne présentent ici pas de différence d'indice avec le substrat puisqu'ils sont gravés dedans. Cela présente un avantage technologique important car la méta-surface est définie directement, de façon monolithique, dans la plateforme de matériau de la couche absorbante (typiquement un semiconducteur de haut indice), sans avoir recours à un report de substrat de faible indice comme dans les méta-surfaces classiques. En effet les méta-surfaces tout diélectrique classiques se présentent sous la forme d'une méta surface d'indice optique fort prise en sandwich entre deux éléments d'indice optique plus faible, soit une succession d'indice de type faible (ex air) / fort/ faible (substrat), alors que ces nouvelles métasurfaces asymétriques présentent une succession d'indice optique de type faible / fort / fort. Les règles de conception pour ces méta-surfaces asymétriques sont significativement différentes.

Ces résonateurs sont agencés et dimensionnés de sorte qu'une fraction Spix de la surface supérieure Ssup associée à un pixel Pix du détecteur comprenne une pluralité de résonateurs diélectriques.

Ces résonateurs sont des méta-surfaces de Huygens qui agissent sur la lumière incidente de manière à réaliser une ou plusieurs fonctions optiques permettant d'améliorer les performances du détecteur.

Ces éléments constituent une monocouche de nano-antennes diélectriques directement gravées dans Lsup en face avant côté illumination, et sont ainsi compatibles d'une technologie planaire. Ils fonctionnent de façon résonnante, exaltant la réponse au voisinage d'une fréquence de résonance λ_{R} (largueur spectrale de la résonance centrée sur λ_{R}) tout en coupant le flux lumineux autour de cette largeur spectrale de résonance.

Ils composent un assemblage de nano-antennes dont les dimensions et l'espacement sont de l'ordre de grandeur de la longueur d'onde de résonance, ou sub-longueur d'onde.

Typiquement au moins une dimension d'un résonateur Res, choisie parmi largueur, longueur, hauteur, est comprise dans l'intervalle [λ_{R}/2n - 50% ; λ_{R}/2n + 50%] ou dans l'intervalle [ λ_{R}/n - 50% ; λ_{R}/n + 50% ], avec :
λ_{R} longueur d'onde de résonance
n indice du matériau supérieur

Préférentiellement chaque fraction Spix de surface supérieure Ssup associée à un pixel comprend au moins 5x5 résonateurs diélectriques.

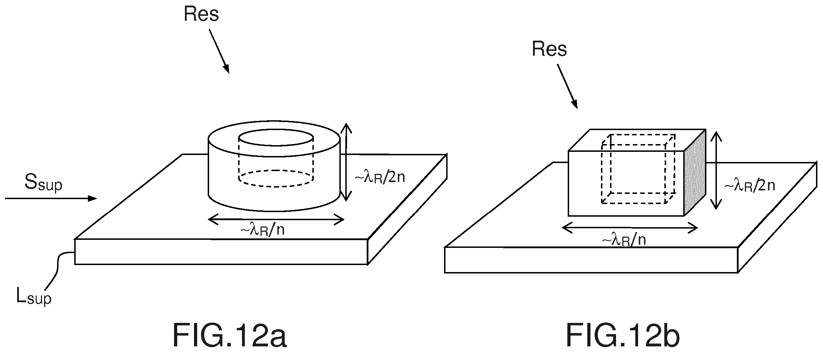

La figure 12 illustre deux exemples de motif de base de résonateurs Res selon l'invention. Typiquement ils présentent une forme circulaire (figure 12a) ou rectangulaire (figure 12b) sous forme de parois, le centre étant creux.

Selon la fonction optique souhaitée, des sous motifs peuvent être gravés dans le motif de base constituant le résonateur, comme les trous au centre des structures des figures 12a et 12b, constituant des sous motifs.

La figure 11 illustre la mise en oeuvre des résonateurs selon l'invention en combinaison avec la variante Loop hole. La différence avec la figure 10 se situe au niveau des trous d'interconnexion IH, mais il s'agit toujours de résonateurs gravés sur la face avant de la couche supérieure en contact avec l'extérieur du côté de l'illumination.

La mise en oeuvre des résonateurs Res selon l'invention est ainsi compatible des deux types de technologie, TSV et Loop hole.

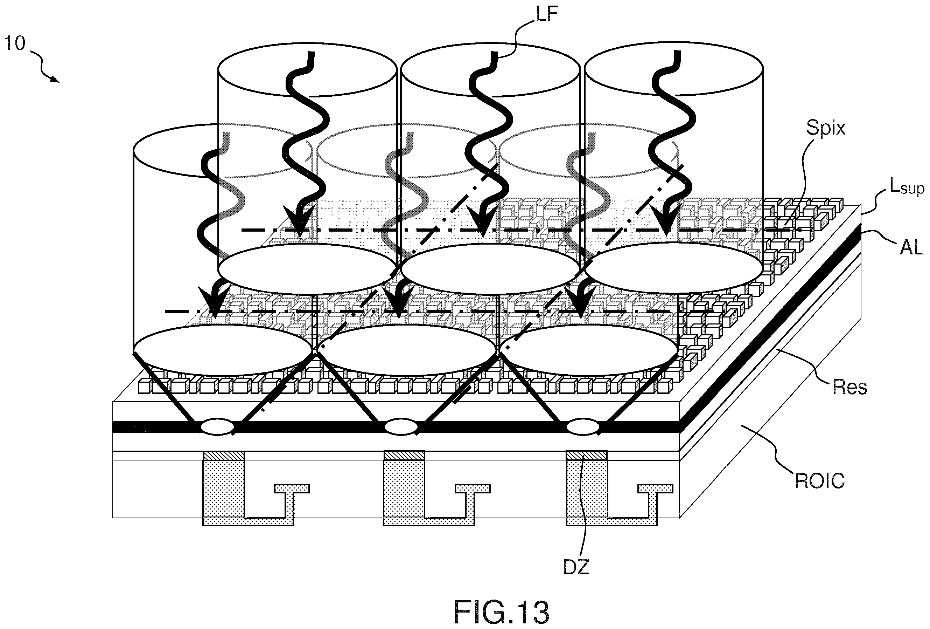

Selon une variante préférée les résonateurs diélectriques Res associés à un pixel Pix sont configurés pour concentrer la lumière rayonnée à la longueur d'onde de résonnance λ_{R} dans la zone dopée DZ correspondante tel qu'illustré figure 13. Les résonateurs jouent le rôle de microlentilles convergentes permettant de focaliser la lumière incidente dans une bande spectrale autour de la longueur d'onde de résonance, au plus près du contact du pixel. On limite ainsi drastiquement les phénomènes de diaphonie optique et électrique, on augmente la sensibilité du capteur ou on permet une diminution de la taille des pixels en maintenant une sensibilité acceptable.

Le profil effectif de la lentille est contrôlé par la disposition des antennes.

Comparé aux structures optiques de type indice effectif (type lentille de Fresnel digitalisée) le principe physique diffère : le front d'onde est modelé du fait d'une phase conférée de manière abrupte, sur une distance très courte devant la longueur d'onde, et non accumulée le long du chemin optique. Un photon incident sur un point de la microlentille est capté par une nano antenne précise, interagit avec elle et est réémis avec une phase donnée. Les profils de lentille ou de miroirs accessibles sont plus variés que pour les structures à indice effectif et on contrôle de manière très précise la focale de la lentille, qui peut être très courte.

En outre l'utilisation de résonateurs selon l'invention permet de réaliser les microlentilles avec une technologie simple en une seule étape, et dont les motifs sont plus larges que ceux nécessaires pour des lentilles de Fresnel digitalisées.

Le calcul du design des résonateurs consiste à chercher à obtenir des interférences constructives vers l'avant à la longueur d'onde de résonance et, hors résonance, des interférences destructives en transmission et donc constructives en réflexion. Cette méthode de calcul et la nature résonnante des antennes aboutit à intégrer intrinsèquement une fonction filtre (des autres longueurs d'onde) et une fonction antireflet (transmission maximale à λ_{R}) dans le design. Un filtrage des autres longueurs d'onde permet par exemple d'assurer une bonne homogénéité de la réponse des pixels sur toute la matrice du détecteur.

En fonction du poids respectif que l'on accorde, lors de l'optimisation, à ces différents aspects, on peut jouer sur les performances respectives de ces trois fonctions : focalisation, antireflet, filtrage spectral.

Ainsi plus généralement la méta-surface assure par design une à trois des fonctions précitées simultanément. La nature résonnante des méta-surfaces permet d'obtenir une transmission proche de 1 à la résonance (antireflet), ainsi qu'un modelage du front d'onde (lentille) à λ_{R} , tout en garantissant une réflexion de la lumière hors résonance (filtre). Autrement dit l'impédance optique du dispositif devient, grâce à la méta-surface, adaptée et spatialement structurée à la résonance et désadaptée hors résonance.

A titre d'exemple, les résonateurs Res sont configurés pour transmettre plus de 70 % de la lumière présentant la longueur d'onde de résonnance λ_{R}, et pour réfléchir au moins en partie les autres longueurs d'onde de la bande spectrale considérée (IR proche, IR moyen ; IR lointain), typiquement plus de 70 %.

Du fait de la souplesse du design des microlentilles, selon un mode de réalisation les résonateurs Res associés à un pixel sont en outre configurés de manière à tenir compte de la position dudit pixel dans la barrette ou la matrice du détecteur. Ceci comporte un intérêt pour la fonction de focalisation, du fait que pour un détecteur recevant une image via une optique d'imagerie, le rayon moyen et l'ouverture angulaire de l'onde incidente sur un pixel dépend de la position du pixel dans le détecteur. Un design spécifique des résonateurs permet d'en tenir compte.

Selon un mode de réalisation les résonateurs sont configurés pour réaliser non pas une fonction convergente classique, mais une fonction plus complexe : lentille de focale nulle, injection sur un mode guidé ou dans une cavité sub-λ pour réduire les épaisseurs de matériau (et donc le courant d'obscurité dans le détecteur.

Selon un mode de réalisation les résonateurs sont configurés pour assurer uniquement une fonction filtrage et /ou une fonction antireflet, sans focalisation.

Selon un mode de réalisation la pluralité de résonateurs associés à un pixel présentent un design spécifique audit pixel : position dans le détecteur, valeur centrale de la bande spectrale de résonance souhaitée...

Lorsque l'invention est appliquée à la variante technologique TSV, les trous d'interconnexion IH traversent le circuit de lecture ROIC, et chaque zone dopée DZ est réalisée dans une couche de contact CL disposée sous la couche absorbante AL, tel qu'illustré figure 10.

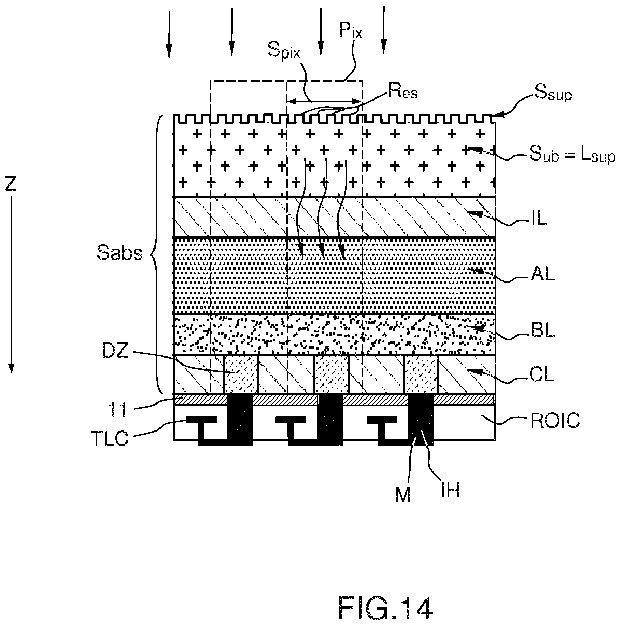

La figure 14 illustre de manière plus détaillée un détecteur 10 selon l'invention réalisé selon la variante TSV.

La structure absorbante Sabs comprend un substrat Sub formant la couche supérieure Lsup, une couche d'interface IL disposée entre le substrat et la couche absorbante AL, une couche barrière BL disposée sous la couche absorbante, et la couche de contact CL comprenant les zones dopées DZ étant disposée sous la couche barrière BL et en contact avec le circuit de lecture via la couche d'assemblage 11.

Selon une variante le substrat Sub n'est pas le substrat initial ayant servi à l'épitaxie, qui a été enlevé et remplacé par un substrat plus rigide, typiquement en silicium.

Lorsque l'invention est appliquée à la variante technologique Loop Hole, les trous d'interconnexion IH traversent la structure absorbante Sabs et le circuit de lecture ROIC jusqu'au contact TLC, chaque zone dopée DZ s'étendant de manière annulaire autour d'un trou d'interconnexion, tel qu'illustré figure 11.

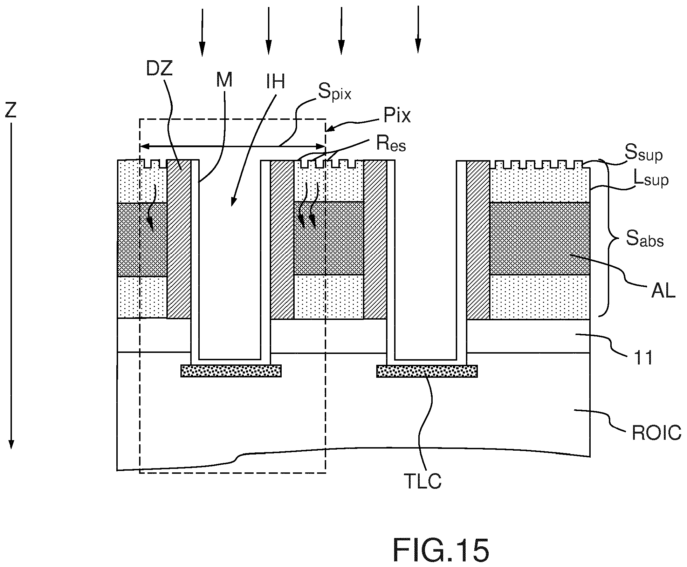

La figure 15 illustre de manière plus détaillée un détecteur 10 selon l'invention réalisé selon la variante Loop Hole, qui reprend la structure décrite figure 1. Ici, la pluralité de résonateur associé à un pixel et réalisant une fonction lentille peut être configurée de manière à focaliser sur un tore ajusté à la géométrie loop hole.

Préférentiellement le matériau actif est choisi parmi les semi conducteurs III-V tels que InGaAs ; InAsSb ; super réseau InAsSb/lnAs ; InSb ; super réseau GaSb/lnAs ; multi-puits quantiques AIInAs/InGaAs ; multi- puits quantiques AIGaAs/GaAs ; AlGaAsSb ; ou parmi les semiconducteurs II-VI tel que HgCdTe.

Préférentiellement le matériau supérieur est choisi parmi : InP ; GaAs ; GaSb ; Si ; SiC ; Diamant.

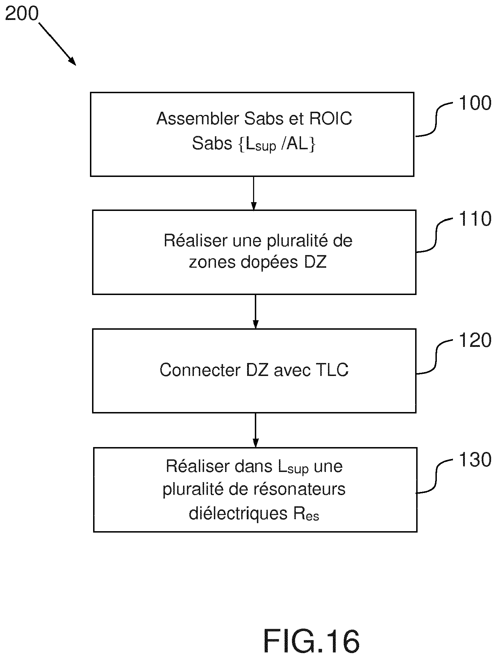

Selon un autre aspect, l'invention concerne un procédé de fabrication 200 d'un détecteur optique de type hybride, tel qu'illustré figure 16.

Dans une première étape 100 on assemble, par une couche d'assemblage 11, une structure absorbante Sabs sensible dans une bande de longueur d'onde d'intérêt SB avec un circuit de lecture ROIC comprenant une pluralité de contacts TLC enterrés.

La structure absorbante Sabs comprend :
- une couche absorbante AL en matériau semi-conducteur III-V ou II-VI dénommé matériau actif, présentant un premier type de dopage dop1 choisi parmi n ou p, apte à photogénérer des porteurs par absorption d'une lumière incidente sur ledit détecteur et présentant au moins une longueur d'onde comprise dans la bande de longueur d'onde d'intérêt,
- une couche supérieure Lsup en un matériau semi-conducteur III-V ou IV dénommé matériau supérieur, disposée sur la couche absorbante et présentant une surface en contact avec l'extérieur du côté par lequel le détecteur est illuminé.

Le circuit de lecture est destiné à récupérer un signal électrique à partir desdits porteurs photogénérés par la couche absorbante AL.

Puis dans une étape 110 on réalise dans au moins une couche de la structure absorbante, une pluralité de zones dopées DZ d'un deuxième type de dopage dop2 choisi parmi n ou p, lesdites zones dopées étant configurées pour collecter des porteurs photogénérés par la couche absorbante. Une zone dopée DZ et un contact TLC du circuit de lecture ROIC étant connectés électriquement via des trous d'interconnexion IH métallisés, une zone dopée permettant de définir un pixel Pix du détecteur.

La position de ces trous ainsi que la forme de la zone dopée DZ dépend de la technologie du détecteur, TSV ou Loop Hole.

On connecte ensuite chaque zones dopée DZ avec le contact associé TLC dans une étape 120, de manière à former les pixels du détecteur, typiquement par une métallisation.

Enfin dans une étape 130 on réalise dans la couche supérieure Lsup un ensemble de résonateurs diélectriques Res formant une surface supérieure Ssup, chaque résonateur étant configuré pour diffuser de manière résonnante au moins une longueur d'onde de résonance λ_{R} comprise dans la bande de longueur d'onde d'intérêt SB. La fraction Spix de la surface supérieure Ssup associée à un pixel Pix du détecteur comprend une pluralité de résonateurs diélectriques.

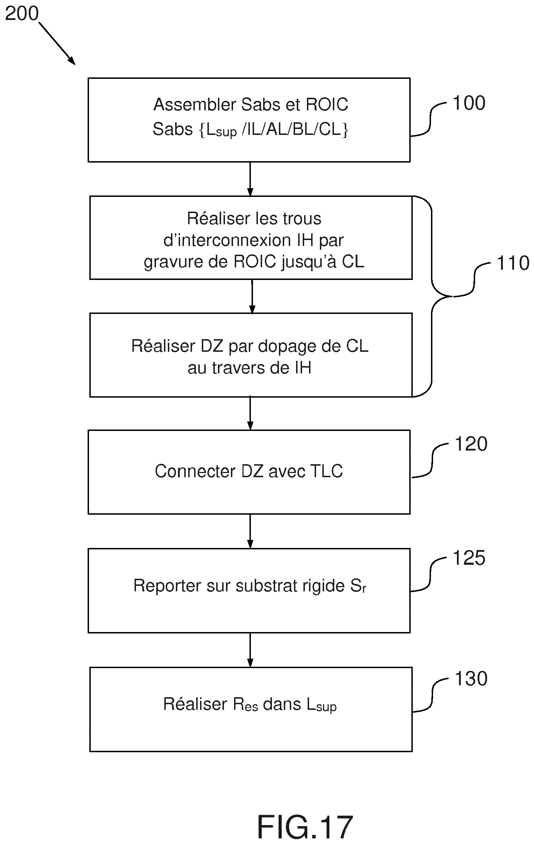

Pour un détecteur en technologie TSV, le procédé 200 est illustré plus en détail figure 17.

La structure absorbante Sabs comprend un substrat Sub formant la couche supérieure, une couche d'interface IL disposée entre le substrat et la couche absorbante AL, une couche barrière BL disposée sous la couche absorbante, et une couche de contact CL comprenant les zones dopées DZ, disposée sous la couche barrière et en contact avec le circuit de lecture ROIC via la couche d'assemblage 11.

L'étape 110 de réalisation d'une pluralité de zones dopées comprend les sous étapes consistant à :
- réaliser les trous d'interconnexion IH par gravure du circuit de lecture ROIC jusqu'à la couche de contact,
- réaliser les zones dopées DZ par dopage de la couche de contact CL au travers des trous d'interconnexion.

Selon une option, le procédé 200 comprend une étape de remplacement d'un substrat initial de la structure absorbante par un substrat rigide Sr, postérieurement à l'étape d'assemblage et antérieurement à l'étape de réalisation d'une pluralité de zones de dopage.

Selon une autre option le procédé comprend en outre, préalablement à l'étape 130 de réalisation des résonateurs, une étape 125 de report sur un substrat rigide Sr.

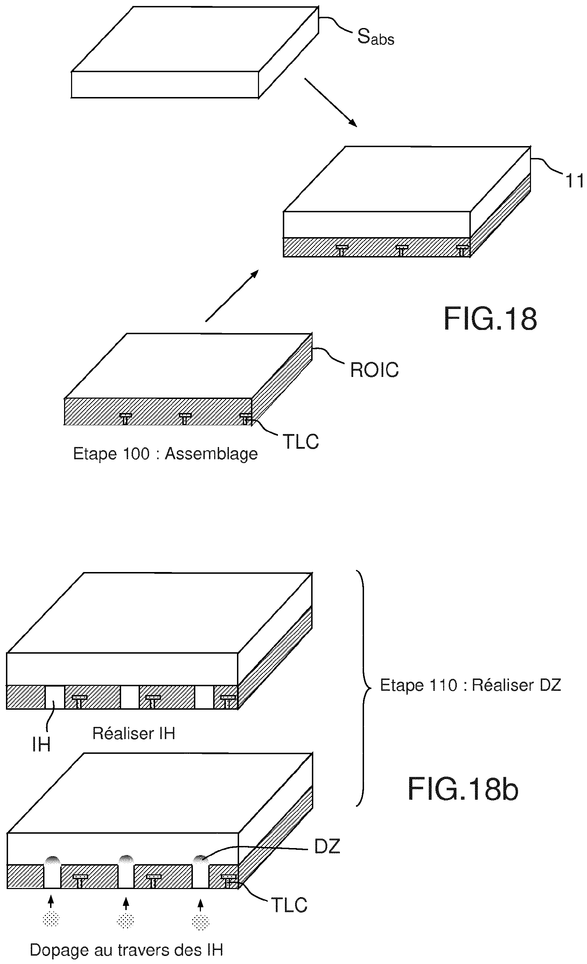

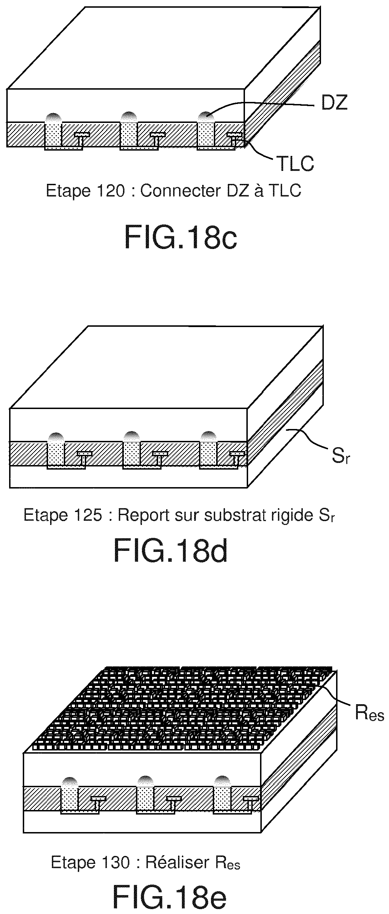

Les différentes étapes du procédé 200 appliqué à la technologie TSV, sont illustrées figure 18.

La figure 18a illustre l'étape 100, la figure 18b l'étape 110, la figure 18c l'étape 120, la figure 18d l'étape 125 et la figure 18e l'étape 130.

Pour un détecteur en technologie Loop hole, l'étape 110 de réalisation d'une pluralité de zones dopées comprend les sous étapes consistant à
- réaliser les trous d'interconnexion IH par gravure de la structure absorbante Sabs et du circuit de lecture ROIC jusqu'aux contacts enterrés TLC,
- réaliser les zones dopées DZ par dopage au travers des trous d'interconnexion, de sorte que chaque zone dopée DZ s'étende de manière annulaire autour du trou d'interconnexion correspondant, comme illustré figures 4 et 5.

Selon une option, préalablement à l'étape de réalisation des résonateurs, on procède à un amincissement de la couche supérieure Lsup.

L'étape de réalisation des résonateurs s'effectue typiquement par lithographie puis gravure, et différentes technologies de lithographie peuvent être utilisées : par faisceau d'électrons ; par nano-impression ; par lithographie optique. La gravure peut être chimique, ionique ou plasma.

## Revendications

1. Détecteur optique (10) de type hybride comprenant un empilement selon un axe Z comprenant :
- une structure absorbante (Sabs) sensible dans une bande de longueur d'onde d'intérêt (SB), ladite structure comprenant au moins :
- une couche absorbante (AL) en matériau semi-conducteur III-V ou II-VI dénommé matériau actif, présentant un premier type de dopage (dop1) choisi parmi n ou p, apte à photogénérer des porteurs par absorption d'une lumière incidente sur ledit détecteur présentant au moins une longueur d'onde comprise dans la bande de longueurs d'onde d'intérêt,
- une couche supérieure (Lsup) en un matériau semi-conducteur III-V ou IV dénommé matériau supérieur, disposée sur la couche absorbante et présentant une surface en contact avec l'extérieur du côté par lequel le détecteur est illuminé et,
- la structure absorbante comprenant en outre, dans au moins une couche, une pluralité de zones dopées (DZ) d'un deuxième type de dopage (dop2) choisi parmi n ou p, et configurées pour collecter des porteurs photogénérés par la couche absorbante, une zone dopée permettant de définir un pixel (Pix) du détecteur,
- un circuit de lecture (ROIC) comprenant une pluralité de contacts (TLC) enterrés, le circuit de lecture étant destiné à récupérer un signal électrique à partir desdits porteurs photogénérés par la couche absorbante (AL),
- la structure absorbante (Sabs) et le circuit de lecture (ROIC) étant assemblés par une couche d'assemblage (11) pour former le détecteur optique (10), une connexion électrique entre une zone dopée et un contact du circuit de lecture (ROIC) étant réalisée via des trous d'interconnexion (IH) métallisés,
- le détecteur hybride comprenant en outre un ensemble de résonateurs diélectriques (Res) gravés dans la couche supérieure (Lsup) et formant une surface supérieure (Ssup), chaque résonateur étant configuré pour diffuser de manière résonnante, lorsqu'éclairé par la lumière incidente, une lumière présentant au moins une longueur d'onde de résonance (λ_{R}) comprise dans la bande de longueur d'onde d'intérêt (SB),
une fraction (Spix) de la surface supérieure (Ssup) associée à un pixel (Pix) du détecteur comprenant une pluralité de résonateurs diélectriques.

2. Détecteur selon la revendication 1 dans lequel les trous d'interconnexion (IH) traversent la structure absorbante et le circuit de lecture (ROIC) jusqu'au contact (TLC) et dans lequel chaque zone dopée (DZ) s'étend de manière annulaire autour d'un trou d'interconnexion.

3. Détecteur selon la revendication 1 dans lequel les trous d'interconnexion (IH) traversent le circuit de lecture (ROIC) et dans lequel chaque zone dopée (DZ) est réalisée dans une couche de contact (CL) disposée sous la couche absorbante (AL).

4. Détecteur selon la revendication 3 dans lequel la structure absorbante (Sabs) comprend un substrat (Sub) formant la couche supérieure, une couche d'interface (IL) disposée entre le substrat et la couche absorbante (AL), une couche barrière (BL) disposée sous la couche absorbante, la couche de contact (CL) comprenant les zones dopées (DZ) étant disposée sous la couche barrière et en contact avec le circuit de lecture via la couche d'assemblage (11).

5. Détecteur selon l'une des revendications précédentes dans lequel au moins une dimension d'un résonateur (Res), choisie parmi largeur, longueur, hauteur, est comprise dans l'intervalle [λ_{R}/2n - 50% ; λ_{R}/2n + 50%] ou dans l'intervalle [ λ_{R}/n - 50% ; λ_{R}/n + 50% ], avec :
λ_{R} longueur d'onde de résonance
n indice du matériau supérieur

6. Détecteur selon l'une des revendications précédentes dans lequel chaque fraction de surface supérieure associée à un pixel (Spix) comprend au moins 5x5 résonateurs diélectriques.

7. Détecteur selon l'une des revendications précédentes dans lequel les résonateurs diélectriques (Res) associés à un pixel sont configurés pour concentrer la lumière rayonnée à la longueur d'onde de résonance (λ_{R}) dans la zone dopée correspondante.

8. Détecteur selon la revendication 7 dans lequel les résonateurs (Res) associés à un pixel sont en outre configurés de manière à tenir compte de la position dudit pixel dans le détecteur.

9. Détecteur selon l'une des revendications 7 ou 8 dans lequel les résonateurs (Res) sont en outre configurés pour transmettre plus de 70 % de la lumière présentant la longueur d'onde de résonance, et pour réfléchir au moins en partie les autres longueurs d'onde de la bande spectrale d'intérêt.

10. Détecteur selon l'une des revendications précédentes dans lequel la pluralité de résonateurs associés à un pixel présente un design spécifique audit pixel.

11. Détecteur selon l'une des revendications précédentes dans lequel la bande de longueur d'onde d'intérêt (SB) est choisie parmi le proche infrarouge, l'infrarouge moyen, l'infrarouge lointain.

12. Détecteur selon l'une des revendications précédentes dans lequel le matériau actif est choisi parmi les semi conducteurs III-V tels que InGaAs ; InAsSb ; super réseau InAsSb/lnAs ; InSb ; super réseau GaSb/lnAs ; multi-puits quantiques AIInAs/InGaAs ; multi-puits quantiques AlGaAs/GaAs ou parmi les semiconducteurs II-VI tel que HgCdTe.

13. Détecteur selon l'une des revendications précédentes dans lequel le matériau supérieur est choisi parmi : InP ; GaAs ; GaSb ; Si ; SiC ; diamant.

14. Procédé de fabrication d'un détecteur optique de type hybride comprenant les étapes consistant à :
- Assembler (100), par une couche d'assemblage (11), une structure absorbante (Sabs) sensible dans une bande de longueur d'onde d'intérêt (SB) avec un circuit de lecture (ROIC) comprenant une pluralité de contacts (TLC) enterrés, la structure absorbante (Sabs) comprenant au moins:
- une couche absorbante (AL) en matériau semi-conducteur III-V ou II-VI dénommé matériau actif, présentant un premier type de dopage (dop1) choisi parmi n ou p, apte à photogénérer des porteurs par absorption d'une lumière incidente sur ledit détecteur et présentant au moins une longueur d'onde comprise dans la bande de longueur d'onde d'intérêt,
- une couche supérieure (Lsup) en un matériau semi-conducteur III-V ou IV dénommé matériau supérieur, disposée sur la couche absorbante et présentant une surface en contact avec l'extérieur du côté par lequel le détecteur est illuminé et,
le circuit de lecture étant destiné à récupérer un signal électrique à partir desdits porteurs photogénérés par la couche absorbante (AL),
- Réaliser (110) dans au moins une couche de la structure absorbante, une pluralité de zones dopées (DZ) d'un deuxième type de dopage (dop2) choisi parmi n ou p, lesdites zones dopées étant configurées pour collecter des porteurs photogénérés par la couche absorbante, une zone dopée (DZ) et un contact (TLC) du circuit de lecture (ROIC) étant connectés électriquement via des trous d'interconnexion (IH) métallisés, une zone dopée permettant de définir un pixel (Pix) du détecteur,
- Connecter (120) chaque zone dopée (DZ) avec le contact associé (TLC),
- Réaliser (130) dans la couche supérieure (Lsup) un ensemble de résonateurs diélectriques (Res) formant une surface supérieure (Ssup), chaque résonateur étant configuré pour diffuser de manière résonnante au moins une longueur d'onde de résonance (λ_{R}) comprise dans la bande de longueur d'onde d'intérêt (SB),
une fraction (Spix) de la surface supérieure (Ssup) associée à un pixel (Pix) du détecteur comprenant une pluralité de résonateurs diélectriques.

15. Procédé selon la revendication 14 dans lequel la structure absorbante comprend un substrat (Sub) formant la couche supérieure, une couche d'interface (IL) disposée entre le substrat et la couche absorbante (AL), une couche barrière (BL) disposée sous la couche absorbante, et une couche de contact (CL) comprenant les zones dopées (DZ), disposée sous la couche barrière et en contact avec le circuit de lecture (ROIC) via la couche d'assemblage (11) et dans lequel l'étape de réalisation d'une pluralité de zones dopées (110) comprend les sous étapes consistant à
- réaliser les trous d'interconnexion (IH) par gravure du circuit de lecture (ROIC)
- réaliser les zones dopées (DZ) par dopage de la couche de contact (CL) au travers des trous d'interconnexion.

16. Procédé selon l'une des revendications 14 ou 15 comprenant en outre, préalablement à l'étape (130) de réalisation des résonateurs, une étape (125) de report sur un substrat rigide (Sr).

17. Procédé selon la revendication 14 dans lequel l'étape (110) de réalisation d'une pluralité de zones dopées comprend les sous étapes consistant à :
- réaliser les trous d'interconnexion (IH) par gravure de la structure absorbante (Sabs) et du circuit de lecture (ROIC) jusqu'aux contacts enterrés (TLC),
- réaliser les zones dopées (DZ) par dopage au travers des trous d'interconnexion, de sorte que chaque zone dopée (DZ) s'étende de manière annulaire autour du trou d'interconnexion correspondant,

18. Procédé selon l'une des revendications 14 à 17 comprenant en outre, préalablement à l'étape de réalisation des résonateurs, une étape d'amincissement de la couche supérieure.

19. Procédé selon l'une des revendications 14 à 18 dans lequel l'étape de réalisation des résonateurs s'effectue par lithographie puis gravure, la technologie de lithographie étant choisie parmi : par faisceau d'électrons ; par nano-impression ; par lithographie optique ,la technologie de gravure étant choisie parmi : voie chimique ; ionique ; ou plasma.

## Patentansprüche

1. Optischer Detektor (10) vom Hybridtyp, der einen Stapel entlang einer Z-Achse umfasst, Folgendes umfassend:
- eine absorbierende Struktur (Sabs), die in einem relevanten Wellenlängenband (SB) empfindlich ist, wobei die Struktur mindestens Folgendes umfasst:
- eine absorbierende Schicht (AL) aus III-V- oder II-VI-Halbleitermaterial, das als aktives Material bezeichnet wird und einen ersten Dotierungstyp (dop1) aufweist, der aus n oder p ausgewählt ist und in der Lage ist, Träger durch Absorption von auf den Detektor einfallendem Licht zu photogenerieren, das mindestens eine Wellenlänge aufweist, die in dem relevanten Wellenlängenband enthalten ist,
- eine obere Schicht (Lsup) aus einem III-V- oder IV-Halbleitermaterial, das als oberes Material bezeichnet wird, die auf der absorbierenden Schicht angeordnet ist und eine Oberfläche aufweist, die mit dem Äußeren der Seite in Kontakt steht, von der aus der Detektor beleuchtet wird, und
- wobei die absorbierende Struktur ferner in mindestens einer Schicht eine Vielzahl von dotierten Bereichen (DZ) eines zweiten Dotierungstyps (dop2) umfasst, der aus n oder p ausgewählt ist, die so konfiguriert sind, dass sie von der absorbierenden Schicht photogenerierte Träger sammeln, wobei ein dotierter Bereich das Definieren eines Pixels (Pix) des Detektors ermöglicht,
- eine Leseschaltung (ROIC), die eine Vielzahl von vergrabenen Kontakten (TLC) umfasst, wobei die Leseschaltung dazu dient, ein elektrisches Signal anhand der von der absorbierenden Schicht (AL) photogenerierten Träger zurückzugewinnen,
- wobei die absorbierende Struktur (Sabs) und die Leseschaltung (ROIC) durch eine Zusammenfügungsschicht (11) zusammengefügt sind, um den optischen Detektor (10) zu bilden, wobei eine elektrische Verbindung zwischen einem dotierten Bereich und einem Kontakt der Leseschaltung (ROIC) über metallisierte Durchgangslöcher (IH) hergestellt wird,
- wobei der Hybriddetektor ferner einen Satz von dielektrischen Resonatoren (Res) umfasst, die in die obere Schicht (Lsup) graviert sind und eine obere Fläche (Ssup) bilden, wobei jeder Resonator so konfiguriert ist, dass er bei Beleuchtung durch das einfallende Licht resonant Licht streut, das mindestens eine Resonanzwellenlänge (λ_{R}) aufweist, die innerhalb des relevanten Wellenlängenbandes (SB) enthalten ist,
wobei ein Teil (Spix) der oberen Fläche (Ssup), der einem Pixel (Pix) des Detektors zugeordnet ist, eine Vielzahl von dielektrischen Resonatoren umfasst.

2. Detektor nach Anspruch 1, wobei die Durchgangslöcher (IH) durch die absorbierende Struktur und die Leseschaltung (ROIC) bis zum Kontakt (TLC) verlaufen und wobei sich jeder dotierte Bereich (DZ) ringförmig um ein Durchgangsloch herum erstreckt.

3. Detektor nach Anspruch 1, wobei die Durchgangslöcher (IH) durch die Leseschaltung (ROIC) verlaufen und wobei jeder dotierte Bereich (DZ) in einer Kontaktschicht (CL) hergestellt ist, die unter der absorbierenden Schicht (AL) angeordnet ist.

4. Detektor nach Anspruch 3, wobei die absorbierende Struktur (Sabs) ein die obere Schicht bildendes Substrat (Sub), eine zwischen dem Substrat und der absorbierenden Schicht (AL) angeordnete Schnittstellenschicht (IL), eine unter der absorbierenden Schicht angeordnete Barriereschicht (BL) umfasst, wobei die die dotierten Bereiche (DZ) umfassende Kontaktschicht (CL) unter der Barriereschicht angeordnet ist und über die Zusammenfügungsschicht (11) in Kontakt mit der Leseschaltung steht.

5. Detektor nach einem der vorhergehenden Ansprüche, wobei mindestens eine Abmessung eines Resonators (Res), ausgewählt aus Breite, Länge, Höhe, in dem Intervall [λ_{R}/2n - 50 %; λ_{R}/2n + 50 %] oder in dem Intervall [λ_{R}/n - 50 %; λ_{R}/n + 50 %] enthalten ist, wobei:
λ_{R} Resonanzwellenlänge
n Index des oberen Materials

6. Detektor nach einem der vorhergehenden Ansprüche, wobei jeder Teil der oberen Fläche, der einem Pixel (Spix) zugeordnet ist, mindestens 5x5 dielektrische Resonatoren umfasst.

7. Detektor nach einem der vorhergehenden Ansprüche, wobei die einem Pixel zugeordneten dielektrischen Resonatoren (Res) so konfiguriert sind, dass sie das bei der Resonanzwellenlänge (λ_{R}) abgestrahlte Licht in dem entsprechenden dotierten Bereich fokussieren.

8. Detektor nach Anspruch 7, wobei die einem Pixel zugeordneten Resonatoren (Res) ferner so konfiguriert sind, dass sie die Position des Pixels im Detektor berücksichtigen.

9. Detektor nach einem der Ansprüche 7 oder 8, wobei die Resonatoren (Res) ferner so konfiguriert sind, dass sie mehr als 70 % des Lichts mit der Resonanzwellenlänge übertragen, und die anderen Wellenlängen des relevanten Spektralbandes mindestens teilweise reflektieren.

10. Detektor nach einem der vorhergehenden Ansprüche, wobei die Vielzahl der einem Pixel zugeordneten Resonatoren ein für das Pixel spezifisches Design aufweist.

11. Detektor nach einem der vorhergehenden Ansprüche, wobei das relevante Wellenlängenband (SB) ausgewählt ist aus Nahinfrarot, mittlerem Infrarot, Ferninfrarot.

12. Detektor nach einem der vorhergehenden Ansprüche, wobei das aktive Material ausgewählt ist aus III-V-Halbleitem wie InGaAs; InAsSb; InAsSb-/InAs-Übergitter; InSb; GaSb-/InAs-Übergitter; AlInAs-/InGaAs-Multi-Quantentöpfen; AlGaAs-/GaAs-Multi-Quantentöpfen oder aus II-VI-Halbleitern wie HgCdTe.

13. Detektor nach einem der vorhergehenden Ansprüche, wobei das obere Material ausgewählt ist aus: InP; GaAs; GaSb; Si; SiC; Diamant.

14. Verfahren zum Herstellen eines optischen Detektors vom Hybridtyp, folgende Schritte umfassend:
- Zusammenfügen (100), durch eine Zusammenfügungsschicht (11), einer absorbierenden Struktur (Sabs), die in einem relevanten Wellenlängenband (SB) empfindlich ist, mit einer Leseschaltung (ROIC), die eine Vielzahl von vergrabenen Kontakten (TLC) umfasst, wobei die absorbierende Struktur (Sabs) mindestens Folgendes umfasst:
- eine absorbierende Schicht (AL) aus III-V- oder II-VI-Halbleitermaterial, das als aktives Material bezeichnet wird und einen ersten Dotierungstyp (dop1) aufweist, der aus n oder p ausgewählt ist, die in der Lage ist, Träger durch Absorption von auf den Detektor einfallendem Licht zu photogenerieren, und mindestens eine Wellenlänge aufweist, die in dem relevanten Wellenlängenband enthalten ist,
- eine obere Schicht (Lsup) aus einem III-V- oder IV-Halbleitermaterial, das als oberes Material bezeichnet wird, die auf der Absorptionsschicht angeordnet ist und eine Oberfläche aufweist, die mit dem Äußeren der Seite in Kontakt steht, von der aus der Detektor beleuchtet wird, und
wobei die Leseschaltung dazu dient, ein elektrisches Signal anhand der von der absorbierenden Schicht (AL) photogenerierten Träger zurückzugewinnen,
- Herstellen (110) in mindestens einer Schicht der absorbierenden Struktur einer Vielzahl von dotierten Bereichen (DZ) eines zweiten Dotierungstyps (dop2), der aus n oder p ausgewählt ist, wobei die dotierten Bereiche so konfiguriert sind, dass sie von der absorbierenden Schicht photogenerierte Träger sammeln, wobei ein dotierter Bereich (DZ) und ein Kontakt (TLC) der Leseschaltung (ROIC) über metallisierte Durchgangslöcher (IH) elektrisch verbunden sind, wobei ein dotierter Bereich das Definieren eines Pixels (Pix) des Detektors ermöglicht,
- Verbinden (120) jedes dotierten Bereichs (DZ) mit dem zugeordneten Kontakt (TLC),
- Herstellen (130) in der oberen Schicht (Lsup) eines Satzes von dielektrischen Resonatoren (Res), die eine obere Fläche (Ssup) bilden, wobei jeder Resonator so konfiguriert ist, dass er mindestens eine Resonanzwellenlänge (λ_{R}), die in dem relevanten Wellenlängenband (SB) enthalten ist, resonant streut,
wobei ein Teil (Spix) der oberen Fläche (Ssup), der einem Pixel (Pix) des Detektors zugeordnet ist, eine Vielzahl von dielektrischen Resonatoren umfasst.

15. Verfahren nach Anspruch 14, wobei die absorbierende Struktur ein Substrat (Sub) umfasst, das die obere Schicht bildet, eine Schnittstellenschicht (IL), die zwischen dem Substrat und der absorbierenden Schicht (AL) angeordnet ist, eine Barriereschicht (BL), die unter der absorbierenden Schicht angeordnet ist, und eine Kontaktschicht (CL), welche die dotierten Bereiche (DZ) umfasst, die unter der Barriereschicht angeordnet ist und über die Zusammenfügungsschicht (11) mit der Leseschaltung (ROIC) in Kontakt steht, und wobei der Schritt des Herstellens einer Vielzahl von dotierten Bereichen (110) folgende Teilschritte umfasst:
- Herstellen der Durchgangslöcher (IH) durch Gravieren der Leseschaltung (ROIC)
- Herstellen der dotierten Bereiche (DZ) durch Dotieren der Kontaktschicht (CL) durch die Durchgangslöcher hindurch.

16. Verfahren nach einem der Ansprüche 14 oder 15, ferner umfassend vor dem Schritt (130) des Herstellens der Resonatoren einen Schritt (125) des Übertragens auf ein starres Substrat (Sr).

17. Verfahren nach Anspruch 14, wobei der Schritt (110) des Herstellens einer Vielzahl von dotierten Bereichen folgende Teilschritte umfasst:
- Herstellen der Durchgangslöcher (IH) durch Gravieren der absorbierenden Struktur (Sabs) und der Leseschaltung (ROIC) bis zu den vergrabenen Kontakten (TLC),
- Herstellen der dotierten Bereiche (DZ) durch Dotieren durch die Durchgangslöcher hindurch, sodass sich jeder dotierte Bereich (DZ) ringförmig um das entsprechende Durchgangsloch erstreckt.

18. Verfahren nach einem der Ansprüche 14 bis 17, ferner umfassend vor dem Schritt des Herstellens der Resonatoren einen Schritt des Ausdünnens der oberen Schicht.

19. Verfahren nach einem der Ansprüche 14 bis 18, wobei der Schritt des Herstellens der Resonatoren durch Lithographie und anschließendes Gravieren erfolgt, wobei die Lithographietechnologie ausgewählt ist aus: Elektronenstrahl-Lithographie; Nanoprint-Lithographie, optischer Lithographie, wobei die Gravurtechnologie ausgewählt ist aus: chemischer Gravur; ionischer Gravur; oder Plasmagravur.

## Claims

1. An optical detector (10) of the hybrid type, comprising a stack in accordance with an axis Z, comprising:
- an absorbent structure (Sabs) which is sensitive in a wavelength band of interest (SB), said structure comprising at least:
- an absorbent layer (AL) made of semi-conductive material III-V or II-VI, which is referred to as active material, having a first doping type (dop1) which is selected from n or p and which is capable of photogenerating carriers by absorbing a light which is incident on said detector and which has at least one wavelength included within the wavelength band of interest,
- an upper layer (Lsup) made of a semi-conductive material III-V or IV, which is referred to as upper material and which is arranged on the absorbent layer and has a surface in contact with the exterior at the side from which the detector is illuminated, and
- the absorbent structure further comprising, in at least one layer, a plurality of zones (DZ) which are doped with a second doping type (dop2), which is selected from n or p, and which are configured in order to collect carriers which are photogenerated by the absorbent layer, a doped zone allowing the definition of a pixel (Pix) of the detector,
- a reading circuit (ROIC) comprising a plurality of contacts (TLC) which are buried, the reading circuit being intended to recover an electrical signal from the carriers which are photogenerated by the absorbent layer (AL),
- the absorbent structure (Sabs) and the reading circuit (ROIC) being assembled by an assembly layer (11) in order to form the optical detector (10), an electrical connection between a doped zone and a contact of the reading circuit (ROIC) being made via metallised interconnection holes (IH),
- the hybrid detector further comprising a set of dielectric resonators (Res) which are engraved in the upper layer (Lsup) and which form an upper surface (Ssup), each resonator being configured to diffuse in a resonating manner, when it is illuminated by the incident light, a light having at least one resonance wavelength (λ_{R}) included within the wavelength band of interest (SB),
a fraction (Spix) of the upper surface (Ssup) associated with a pixel (Pix) of the detector comprising a plurality of dielectric resonators.

2. The detector according to claim 1, wherein the interconnection holes (IH) extend through the absorbent structure and the reading circuit (ROIC) as far as the contact (TLC) and wherein each doped zone (DZ) extends annularly around an interconnection hole.

3. The detector according to claim 1, wherein the interconnection holes (IH) extend through the reading circuit (ROIC) and wherein each doped zone (DZ) is realised in a contact layer (CL) which is arranged under the absorbent layer (AL).

4. The detector according to claim 3, wherein the absorbent structure (Sabs) comprises a substrate (Sub) which forms the upper layer, an interface layer (IL) which is arranged between the substrate and the absorbent layer (AL), a barrier layer (BL) which is arranged under the absorbent layer, the contact layer (CL) comprising the doped zones (DZ) being arranged under the barrier layer and in contact with the reading circuit via the assembly layer (11).

5. The detector according to any one of the preceding claims, wherein at least one dimension of a resonator (Res), which is selected from the width, length, height, is included within the range [λ_{R}/2n - 50 %; λ_{R}/2n + 50 %] or within the range [λ_{R}/n - 50 %; λ_{R}/n + 50 %], with:
λ_{R} resonance wavelength,
n index of the upper material.

6. The detector according to any one of the preceding claims, wherein each upper surface fraction associated with a pixel (Spix) comprises at least 5x5 dielectric resonators.

7. The detector according to any one of the preceding claims, wherein the dielectric resonators (Res) which are associated with a pixel are configured to concentrate the radiated light at the resonance wavelength (λ_{R}) in the corresponding doped zone.

8. The detector according to claim 7, wherein the resonators (Res) which are associated with a pixel are further configured so as to take account of the position of the pixel in the detector.

9. The detector according to any one of claims 7 or 8, wherein the resonators (Res) are further configured to transmit more than 70 % of the light having the resonance wavelength and to at least partially reflect the other wavelengths of the spectral band of interest.

10. The detector according to any one of the preceding claims, wherein the plurality of resonators which are associated with a pixel has a design which is specific to the pixel.

11. The detector according to any one of the preceding claims, wherein the wavelength band of interest (SB) is selected from near infrared, mid infrared, far infrared.

12. The detector according to any one of the preceding claims, wherein the active material is selected from the semiconductors III-V, such as InGaAs; InAsSb; super-lattice InAsSb/InAs; InSb; super-lattice GaSb/InAs; quantum multi-wells AlInAs/InGaAs; quantum multi-wells AlGaAs/GaAs or from semiconductors II-VI such as HgCdTe.

13. The detector according to any one of the preceding claims, wherein the upper material is selected from: InP; GaAs; GaSb; Si; SiC; diamond.

14. A method for manufacturing an optical detector of the hybrid type, comprising:
- assembling (100), via an assembly layer (11), an absorbent structure (Sabs) sensitive in a wavelength band of interest (SB) with a reading circuit (ROIC) comprising a plurality of buried contacts (TLC), the absorbent structure (Sabs) comprising at least:
- an absorbent layer (AL) made of semi-conductive material III-V or II-VI, which is referred to as active material, having a first doping type (dop1) which is selected from n or p and which is capable of photogenerating carriers by absorbing a light which is incident on said detector and which has at least one wavelength included within the wavelength band of interest,
- an upper layer (Lsup) made of a semi-conductive material III-V or IV, which is referred to as upper material, which is arranged on the absorbent layer and has a surface in contact with the exterior at the side from which the detector is illuminated, and the reading circuit being intended to recover an electrical signal from the photogenerated carriers by the absorbent layer (AL),
- realising (110) in at least one layer of the absorbent structure a plurality of zones (DZ) which are doped with a second doping type (dop2) which is selected from n or p, the doped zones being configured in order to collect carriers which are photogenerated by the absorbent layer, a doped zone (DZ) and a contact (TLC) of the reading circuit (ROIC) being electrically connected via metallised interconnection holes (IH), a doped zone allowing the definition of a pixel (Pix) of the detector,
- connecting (120) each doped zone (DZ) with the associated contact (TLC),
- realising (130) in the upper layer (Lsup) assembly set of dielectric resonators (Res) which form an upper surface (Ssup), each resonator being configured to diffuse in a resonating manner at least one resonance wavelength (λ_{R}) included within the wavelength band of interest (SB),
a fraction (Spix) of the upper surface (Ssup) associated with a pixel (Pix) of the detector comprising a plurality of dielectric resonators.

15. The method according to claim 14, wherein the absorbent structure comprises a substrate (Sub) which forms the upper layer, an interface layer (IL) which is arranged between the substrate and the absorbent layer (AL), a barrier layer (BL) which is arranged under the absorbent layer and a contact layer (CL) comprising the doped zones (DZ) which is arranged under the barrier layer and in contact with the reading circuit (ROIC) via the assembly layer (11) and in which the step of realising a plurality of doped zones (110) comprises the following sub-steps:
- realising the interconnection holes (IH) by etching the reading circuit (ROIC),
- realising the doped zones (DZ) by doping the contact layer (CL) through the interconnection holes.

16. The method according to any one of claims 14 or 15, further comprising, before the step (130) of realising the resonators, a step (125) of transferring to a rigid substrate (Sr).

17. The method according to claim 14, wherein the step (110) of realising a plurality of doped zones comprises the following sub-steps:
- realising the interconnection holes (IH) by etching the absorbent structure (Sabs) and the reading circuit (ROIC) as far as the embedded contacts (TLC),
- realising the doped zones (DZ) by doping through the interconnection holes so that each doped zone (DZ) extends annularly around the corresponding interconnection hole.

18. The method according to any one of claims 14 to 17, further comprising, before the step of realising the resonators, a step of thinning the upper layer.

19. The method according to any one of claims 14 to 18, wherein the step of realising the resonators is carried out by lithography, then etching, the lithography technology being selected from: electron beam lithography; nano-imprint lithography; optical lithography, the etching technology being selected from: chemical etching; ion etching; or plasma etching.
